# EUROPEAN PATENT APPLICATION

(11) **EP 4 576 981 A1**
(43) Date of publication of application: **25.06.2025**
(21) Application number: 24191338.3
(22) Date of filing: 29.07.2024
(51) Int. Cl.: H10B 63/00, H10N 70/20

(54) **VERTICAL NON-VOLATILE MEMORY DEVICE INCLUDING MEMORY CELL STRING**

(30) Priority: 18.12.2023 KR 20230185070
(71) Applicant: SAMSUNG ELECTRONICS CO., LTD., Yeongtong-gu Suwon-si, Gyeonggi-do 16677 (KR)
(72) Inventor: KANG, Youngjae, 16678 Suwon-si (KR); KOO, Bonwon, 16678 Suwon-si (KR); PARK, Yongyoung, 16678 Suwon-si (KR); PARK, Jongbong, 16678 Suwon-si (KR); YANG, Kiyeon, 16678 Suwon-si (KR); YANG, Wooyoung, 16678 Suwon-si (KR); LEE, Changseung, 16678 Suwon-si (KR); CHOI, Minwoo, 16678 Suwon-si (KR)
(74) Representative: Elkington and Fife LLP

(57) **Abstract**

A vertical non-volatile memory device may include a plurality of memory cell strings arranged two-dimensionally. Each of the plurality of memory cell strings may include a channel layer extending in a first direction, a plurality of gate electrodes and a plurality of spacers alternately arranged in the first direction and each extending in a second direction, a gate insulating film extending in the first direction and between the channel layer and the plurality of gate electrodes, and a resistance change layer extending in the first direction along a surface of the channel layer. The second direction may cross the first direction. A material in the resistance change layer may be capable of switching between a first state having a first threshold voltage and a second state having a second threshold voltage. The second threshold voltage may be greater than the first threshold voltage.

## Description

### FIELD OF THE INVENTION

The disclosure relates to a vertical non-volatile memory device including a memory cell string.

### BACKGROUND OF THE INVENTION

A non-volatile memory device, such as a semiconductor memory device, includes a plurality of memory cells that can retain information even in a power-off state and use the stored information again when power is supplied thereto. Non-volatile memory devices may be used in mobile phones, digital cameras, personal digital assistants (PDAs), portable computer devices, stationary computer devices, and other devices.

An example of a non-volatile memory device includes a vertical NAND (VNAND). VNAND is a memory device with increased integration by vertically stacking a large number of memory cells. Various technologies have been proposed to realize high capacity in the same region by increasing the number of VNAND stacks. For example, in order to implement VNAND, various technologies, for example, methods using charge traps, methods using phase change materials, methods using resistance change materials, methods using ferroelectrics, and the like, have been proposed. Furthermore, various materials have been researched to improve the performance of a non-volatile memory device, for example, improvement of data reliability, improvement of a driving speed, reduction of consumption power, increase of a degree of integration, and the like.

### SUMMARY OF THE INVENTION

Provided is a vertical non-volatile memory device including a memory cell string.

Additional aspects will be set forth in part in the description which follows and, in part, will be apparent from the description, or may be learned by practice of the presented embodiments.

According to an embodiment of the disclosure, a vertical non-volatile memory device, may include a plurality of memory cell strings arranged two-dimensionally. Each of the plurality of memory cell strings may include a channel layer extending in a first direction, a plurality of gate electrodes and a plurality of spacers alternately arranged in the first direction and each extending in a second direction crossing the first direction, a gate insulating film extending in the first direction and between the channel layer and the plurality of gate electrodes, and a resistance change layer extending in the first direction along a surface of the channel layer. A material in the resistance change layer may be capable of switching between a first state having a first threshold voltage and a second state having a second threshold voltage. The second threshold voltage may be greater than the first threshold voltage.

In some embodiments, no current flows in the resistance change layer if the resistance change layer is in the first state and a voltage less than the first threshold voltage is applied to the resistance change layer; current flows in the resistance change layer if the resistance change layer is in the first state and a voltage greater than or equal to the first threshold voltage is applied to the resistance change layer; no current flows in the resistance change layer if the resistance change layer is in the second state and a voltage less than the second threshold voltage is applied to the resistance change layer; and current flows in the resistance change layer if the resistance change layer is in the second state and a voltage greater than or equal to the second voltage is applied to the resistance change layer.

In some embodiments, the resistance change layer may be configured to switch from the first state to the second state in response to the resistance change layer being in the first state while a sufficient negative (-) bias voltage is applied to the resistance change layer, and the resistance change layer may be configured to switch from the first state to the second state in response to the resistance change layer being in the second state while a positive (+) bias voltage greater than the second threshold voltage is applied to the resistance change layer.

In some embodiments, the non-volatile memory device may be configured to perform a read operation that includes applying a read voltage between the first threshold voltage and the second threshold voltage to the resistance change layer.

In some embodiments, the resistance change layer may have a single layer structure including at least one amorphous multi-component chalcogenide material among GeAsSe, GeAsSeln, GeAsSeSln, GeAsSeSb, GeAsSeSbln, GeAsSeTe, GeAsSeTeln, GeAsSeAl, GeAsSeAlln, GeSbSe, GeSbSeln, GeSbSeN, GeSbSeNln, CTe, GeCTe, NGeCTe, BTe, SiTe, GeAsTe, GeSbSe, and GeSbSeN.

In some embodiments, a ratio of germanium (Ge) in the resistance change layer may be 10 at% to 30 at%.

In some embodiments, a ratio of arsenic (As) in the resistance change layer may be10 at% to 50 at%.

In some embodiments, a ratio of selenium (Se) in the resistance change layer may be 40 at% to 80 at%.

In some embodiments, a ratio of indium (In) in the resistance change layer may be 1 at% to 10 at%.

In some embodiments, the resistance change layer may include a plurality of driving regions and a plurality of pristine-state regions alternately arranged in the first direction.

In some embodiments, each of the plurality of driving regions may face a corresponding gate electrode of the plurality of gate electrodes in the second direction, and each of the plurality of pristine-state regions may face a corresponding insulating spacer of the plurality of insulating spacers in the second direction.

In some embodiments, in response to a voltage greater than or equal to the first threshold voltage being applied to the resistance change layer, a resistance of the plurality of pristine-state regions may be greater than a resistance of the plurality of driving regions.

In some embodiments, in response to a voltage greater than or equal to the first threshold voltage being applied to both the plurality of pristine-state regions and the plurality of driving regions, a resistance of the plurality of pristine-state regions may be greater than a resistance of the plurality of driving regions.

In some embodiments, each of the plurality of driving regions may include a first region and a second region having different densities of activated traps.

In some embodiments, if the resistance change layer is in the first state, a density of activated traps in the second region may be greater than a density of activated traps in the first region. If the resistance change layer is in the second state, the density of activated traps in the second region may be less than the density of activated traps in the first region.

In some embodiments, a thickness of the second region in the first direction may be less than a thickness of the first region in the first direction.

In some embodiments, thickness of the first region in the first direction may be 2 times to 10 times the thickness of the second region in the first direction.

In some embodiments, the resistance change layer may have a property where, during switching between the first state and the second state, an element composition distribution in the first region and the second region may be maintained constant.

In some embodiments, a thickness of the resistance change layer in the second-direction may be 5 nm to 100 nm.

In some embodiments, each of the plurality of memory cell strings may further include a barrier layer extending in the first direction between the channel layer and the resistance change layer. The barrier layer may include a carbon-based non-conductor or a nitrogen-based non-conductor, and the thickness of the barrier layer in the second-direction may be greater than 0 nm and less than or equal to 10 nm.

According to an embodiment of the disclosure, an electronic device may include
a processing circuitry; and a vertical non-volatile memory device connected to the processing circuitry, the vertical non-volatile memory device including a plurality of memory cell strings arranged two-dimensionally. Each of the plurality of memory cell strings may include a channel layer extending in a first direction, a plurality of gate electrodes and a plurality of spacers alternately arranged in the first direction and each extending in a second direction, the second direction crossing the first direction, a gate insulating film extending in the first direction and between the channel layer and the plurality of gate electrodes; and a resistance change layer extending in the first direction along a surface of the channel layer. A material in the resistance change layer may be capable of switching between a first state having a first threshold voltage and a second state having a second threshold voltage. The second threshold voltage may be greater than the first threshold voltage.

### BRIEF DESCRIPTION OF THE DRAWINGS

These and/or other aspects will become apparent and more readily appreciated from the following description of the embodiments, taken in conjunction with the accompanying drawings in which:
FIG. 1 is a block diagram of a memory system according to an embodiment;
FIG. 2 is a block diagram showing an example of a memory device of FIG. 1;
FIG. 3 is a block diagram of a memory cell array of FIG. 1;
FIG. 4 is an equivalent circuit corresponding to a memory block according to an embodiment;
FIG. 5 is a schematic vertical cross-sectional view showing a structure of a memory cell string according to an embodiment;
FIG. 6 is a schematic horizontal cross-sectional view showing a structure of a memory cell string according to an embodiment;
FIG. 7 is a graph showing voltage-current characteristics of a resistance change layer of a memory cell string according to an embodiment;
FIG. 8A is a graph showing an example of a bias voltage for a SET operation and a read operation in the resistance change layer of a memory cell string according to an embodiment;
FIG. 8B is a graph showing an example of a bias voltage for a RESET operation and a read operation in the resistance change layer of a memory cell string according to an embodiment;
FIG. 9A is a conceptual view showing an example of a trap state in a resistance change layer material when the resistance change layer material is in a pristine state, and FIG. 9B is a schematic energy band diagram of the resistance change layer material in the pristine state;
FIG. 10A is a conceptual view showing an example of a trap state in the resistance change layer material after a positive (+) bias voltage for first-firing is applied to the resistance change layer material in a pristine state, FIG. 10B is a schematic energy band diagram of the resistance change layer material around a first end portion after the first-firing, and FIG. 10C is a schematic energy band diagram of the resistance change layer material around a second end portion after the first-firing;
FIG. 11A is a conceptual view showing an example of a trap state in the resistance change layer material after a negative (-) bias voltage is applied to the first-fired resistance change layer material, FIG. 11B is a schematic energy band diagram of the resistance change layer material around the first end portion after the application of the negative bias voltage, and FIG. 11C is a schematic energy band diagram of the resistance change layer material around the second end portion after the application of the negative bias voltage;
FIG. 12A illustrates an example of a SET operation of a memory cell string according to an embodiment, and FIG. 12B schematically shows an example of a RESET operation of a memory cell string according to an embodiment;
FIG. 13 illustrates an example of regions formed in the resistance change layer after the first-firing of a memory cell string according to an embodiment;
FIG. 14 is a vertical cross-sectional view showing a structure manufactured to check an actual operation of a memory cell string according to an embodiment;
FIG. 15 is a graph showing an example of the voltage-current characteristics of the structure of FIG. 14 in a pristine state, a SET state, and a RESET state;
FIG. 16 is a schematic vertical cross-sectional view showing a structure of a memory cell string according to another embodiment;
FIG. 17 is a schematic conceptual view of a device architecture applicable to an example electronic device including a memory device according to an embodiment; and
FIG. 18 is a schematic block diagram of a neuromorphic apparatus including a memory device according to an embodiment.

### DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Hereinafter, a vertical non-volatile memory device including a memory cell string will be described in detail with reference to the accompanying drawings. Throughout the drawings, like reference numerals denote like elements, and sizes of components in the drawings may be exaggerated for convenience of explanation and clarity. Furthermore, as embodiments described below are examples, other modifications may be produced from the embodiments.

When a constituent element is disposed "above" or "on" to another constituent element, the constituent element may be only directly on the other constituent element or above the other constituent elements in a non-contact manner. As used herein, the singular forms "a," "an," and "the" are intended to include the plural forms as well, unless the context clearly indicates otherwise. Furthermore, it will be further understood that the terms "comprises" and/or "comprising" used herein specify the presence of stated features or components, but do not preclude the presence or addition of one or more other features or components.

The use of the terms "a," "an," "the," and similar referents in the context of describing the disclosure are to be construed to cover both the singular and the plural. Also, the operations of all methods described herein can be performed in any suitable order unless otherwise indicated herein or otherwise clearly contradicted by context. The disclosure is not limited to the described order of the steps.

Furthermore, terms such as "... portion," "... unit," "... module," and "... block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

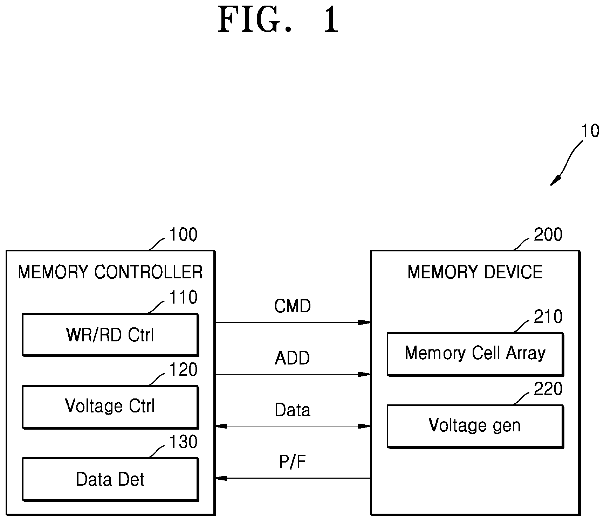

FIG. 1 is a block diagram of a memory system 10 according to an embodiment. Referring to FIG. 1, the memory system 10 according to an embodiment may include a memory controller 100 and a memory device 200. The memory controller 100 may perform a control operation on the memory device 200. In an example, the memory controller 100 may perform a program (or write), read, or erase operation on the memory device 200 by providing an address ADD and a command CMD to the memory device 200. Furthermore, data for a program operation and read data may be transceived between the memory controller 100 and the memory device 200. The memory device 200 may provide a pass/fail signal to the memory controller 100 according to a read result of the read data, and the memory controller 100 may control a write/read operation on a memory cell array 210 in response to the pass/fail signal.

The memory device 200 may include the memory cell array 210 and a voltage generator 220. The memory cell array 210 may include a plurality of memory cells arranged in regions where a plurality of word lines and a plurality of bit lines cross each other. The memory cell array 210 may include non-volatile memory cells that non-volatilely store data, and as non-volatile memory cells, the memory cell array 210 may include flash memory cells, such as a NAND flash memory cell array 210, a NOR flash memory cell array 210, or the like. In the following description, embodiments of the disclosure are described assuming that the memory cell array 210 includes a flash memory cell array 210, and thus, the memory device 200 is a non-volatile memory device.

The memory controller 100 may include a write/read controller 110, a voltage controller 120, and a data determination unit 130.

The write/read controller 110 may generate the address ADD and the command CMD to perform program/read and erase operations on the memory cell array 210. Furthermore, the voltage controller 120 may generate a voltage control signal to control at least one voltage level used in the memory device 200 that is non-volatile. For example, the voltage controller 120 may generate a voltage control signal to control a voltage level of a word line to read data from the memory cell array 210 or program data to the memory cell array 210.

The data determination unit 130 may perform a determination operation on the data read from the memory device 200. For example, by determining the data read from the memory cells, the data determination unit 130 may determine the number of on-cells and/or off-cells among the memory cells. As an example operation, when a program is performed on a plurality of memory cells, by determining a state of data of the memory cells using a certain read voltage, whether the program is normally completed for all cells may be determined.

As described above, the memory cell array 210 may include non-volatile memory cells, for example, flash memory cells. Furthermore, the flash memory cells may be implemented in various forms. For example, the memory cell array 210 may include three-dimensional (or vertical) NAND (VNAND) memory cells.

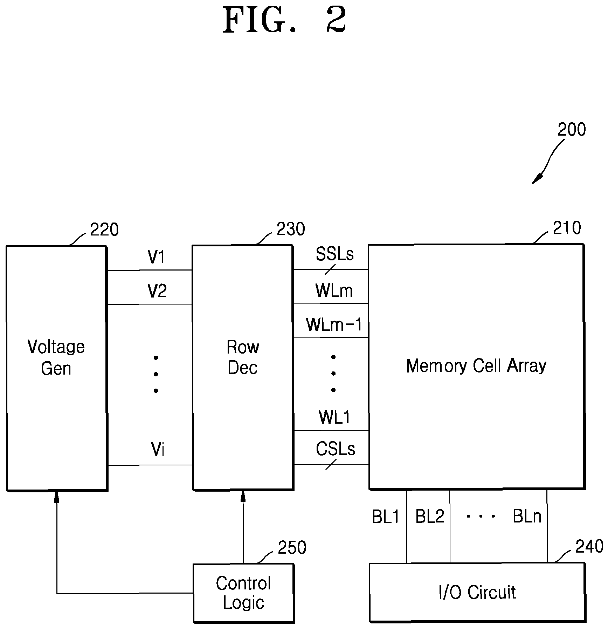

FIG. 2 is a block diagram showing an example of the memory device 200 of FIG. 1. Referring to FIG. 2, the memory device 200 may include a row decoder 230, an input/output circuit 240, and a control logic 250.

The memory cell array 210 may be connected to one or more string select lines SSLs, a plurality of word lines WL1 to WLm, and one or more common source lines CSLs, and furthermore, to a plurality of bit lines BL1 to BLn. The voltage generator 220 may generate one or more word line voltages V1 to Vi, and the word line voltages V1 to Vi may be provided to the row decoder 230. Signals for program/read/erase operations may be applied to the memory cell array 210 through the bit lines BL1 to BLn.

Furthermore, data to be programmed may be provided to the memory cell array 210 through the input/output circuit 240, and data that is read may be provided to the outside (e.g., the memory controller 100) through the input/output circuit 240. The control logic 250 may provide various control signals related to memory operations to the row decoder 230 and the voltage generator 220.

The word line voltages V1 to Vi may be provided through various lines (SSLs, WL1 to WLm, CSLs) according to a decoding operation of the row decoder 230. For example, the word line voltages V1 to Vi may include a string select voltage, a word line voltage, and a ground select voltage, and the string select voltage may be provided to the string select lines SSLs, the word line voltage may be provided to the word lines WL1 to WLm, and the ground select voltage may be provided to the common source lines CSLs.

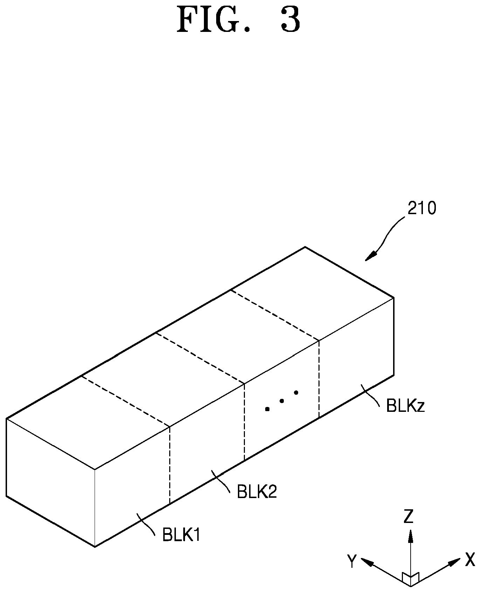

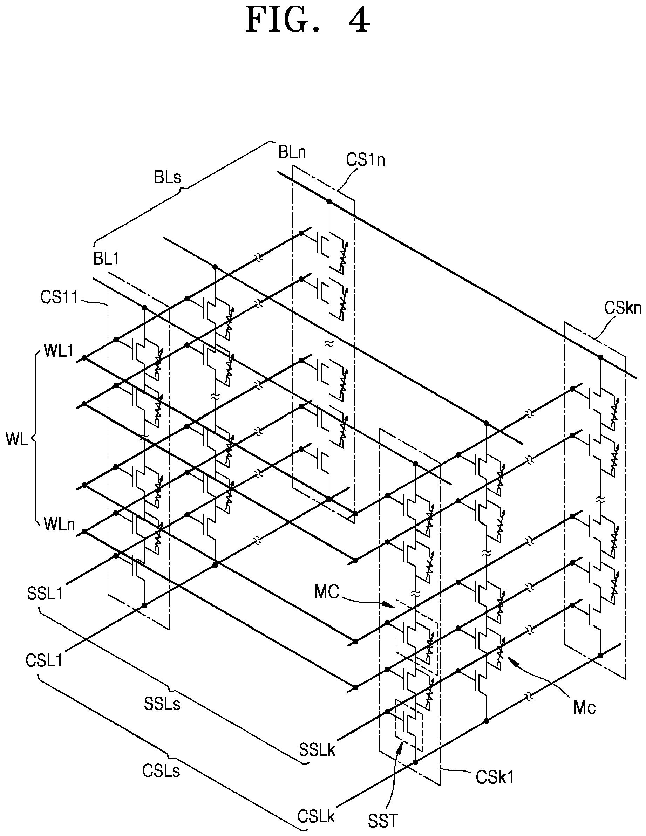

FIG. 3 is a block diagram of the memory cell array 210 of FIG. 1. Referring to FIG. 3, the memory cell array 210 may include a plurality of memory blocks BLK1 to BLKz. Each memory block BLK may have a three-dimensional structure (or a vertical structure). For example, each memory block BLK may include a structure extending in first to third directions. For example, each memory block BLK may include a plurality of memory cell strings extending in the first direction (Z direction). Furthermore, a plurality of memory cell strings may be arranged two-dimensionally in the second and third directions (X and Y directions). Each memory cell string is connected to the bit line BL, the string select line SSL, the word lines WLs, and the common source line CSL. Accordingly, the memory blocks BLK1 to BLKz may be respectively connected to the bit lines BLs, the string select lines SSLs, the word lines WLs, and the common source lines CSLs. The memory blocks BLK1 to BLKz configured as above are described in detail with reference to FIG. 4.

FIG. 4 is an equivalent circuit corresponding to a memory block according to an embodiment. For example, FIG. 4 illustrates one of the memory blocks BLK1 to BLKz of the memory cell array 210 of FIG. 3. Referring to FIGS. 3 and 4, the memory blocks BLK1 to BLKz may each include a plurality of memory cell strings CS11 to CSkn. The memory cell strings CS11 to CSkn may be arranged two-dimensionally in a row direction and a column direction to thus form rows and columns. Each of the memory cell strings CS11 to CSkn may include a plurality of memory cells MCs and a plurality of string select transistors SSTs. The memory cells MCs and the string select transistors SSTs of each of the memory cell strings CS11 to CSkn may be stacked in a height direction.

Rows of the memory cell strings CS11 to CSkn are connected to different string select lines SSL1 to SSLk, respectively. For example, the string select transistors SSTs of the memory cell strings CS11 to CS1n are connected in common to the string select line SSL1. The string select transistors SSTs of the memory cell strings CSk1 to CSkn are connected in common to the string select line SSLk.

Furthermore, the columns of the memory cell strings CS11 to CSkn are connected to different bit lines BL1 to BLn, respectively. For example, the memory cells MCs and the string select transistors SSTs of the memory cell strings CS11 to CSk1 may be connected in common to the bit line BL1, and the memory cells MCs and the string select transistors SSTs of the memory cell strings CS1 n to CSkn may be connected in common to the bit line BLn.

Furthermore, rows of the memory cell strings CS11 to CSkn may be connected to different common source lines CSL1 to CSLk, respectively. For example, the string select transistors SSTs of the memory cell strings CS11 to CS1n may be connected in common to the common source line CSL1, and the string select transistors SSTs of the memory cell strings CSk1 to CSkn may be connected in common to the common source line CSLk.

The memory cells MCs located at the same height from a substrate (or the string select transistors SSTs) may be connected in common to one word line WL, and the memory cells MCs located at different height may be connected to different word lines WL1 to WLm, respectively.

The memory block illustrated in FIG. 4 is an example. The technical concepts of the disclosure are not limited to the memory block illustrated in FIG. 4. For example, the number of rows of the memory cell strings CS11 to CSkn may be increased or decreased. As the number of rows of the memory cell strings CS11 to CSkn is changed, the number of the string select lines SSL1 to SSLk connected to the rows of the memory cell strings CS11 to CSkn, and the number of the memory cell strings CS11 to CSkn connected to one bit line, may also be changed. As the number of the rows of the memory cell strings CS11 to CSkn is changed, the number of the common source lines CSL1 to CSLk connected to the rows of the memory cell strings CS11 to CSkn may also be changed. Furthermore, the number of the columns of the memory cell strings CS11 to CSkn may be increased or decreased. As the number of the columns of the memory cell strings CS11 to CSkn is changed, the number of the bit lines BLs connected to the columns of the memory cell strings CS11 to CSkn, and the number of the memory cell strings CS11 to CSkn connected to one string select line SSL, may also be changed.

The height of each of the memory cell strings CS11 to CSkn may be increased or decreased. For example, the number of the memory cells MCs stacked on each of the memory cell strings CS11 to CSkn may be increased or decreased. As the number of the memory cells MCs stacked on each of the memory cell strings CS11 to CSkn is changed, the number of the word lines WLs may also be changed. For example, the number of the string select transistors SSTs provided to each of the memory cell strings CS11 to CSkn may be increased. As the number of the string select transistors SSTs provided to each of the memory cell strings CS11 to CSkn is changed, the number of the string select lines SSL or the common source lines CSLs may also be changed. As the number of the string select transistors SSTs is increased, the string select transistors SSTs may be stacked in the same form as the memory cells MC.

For example, the write and read operations may be performed for each row of the memory cell strings CS11 to CSkn. The memory cell strings CS11 to CSkn may be selected for each row by the common source lines CSLs, and the memory cell strings CS11 to CSkn may be selected for each row by the string select lines SSLs. In a selected row of the memory cell strings CS11 to CSkn, the write and read operations may be performed for each page. For example, a page may be one row of the memory cells MCs connected to one word line WL. The memory cells MCs may be selected for each page by the word lines WL in the selected row of the memory cell strings CS11 to CSkn.

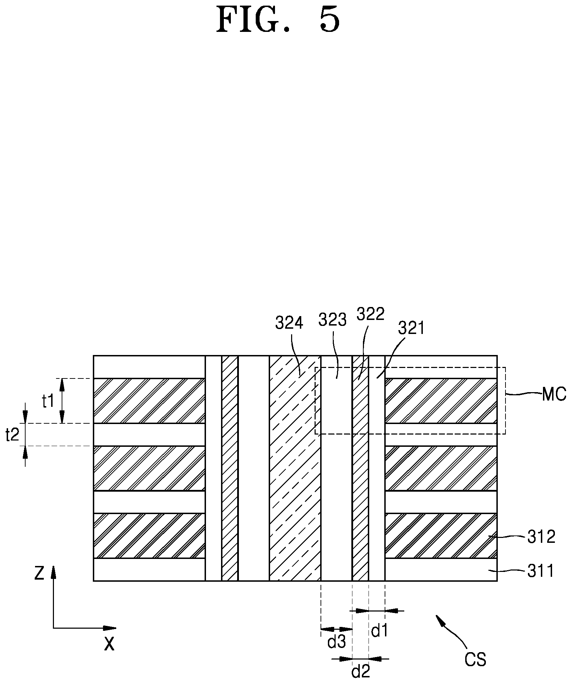

The memory cells MCs in each of the memory cell strings CS11 to CSkn may correspond to a circuit in which a transistor and a resistor are connected in parallel. For example, FIG. 5 is a schematic vertical cross-sectional view of a structure of each memory cell string CS according to an embodiment. Referring to FIG. 5, the memory cell string CS may include a plurality of insulating spacers 311 and a plurality of gate electrodes 312, which are alternatively stacked in a vertical direction perpendicularly crossing the second direction (X direction), that is, in the first direction (Z direction). The insulating spacers 311 and the gate electrodes 312 may extend in a horizontal direction, that is, the second direction. Each gate electrode 312 may be connected to the word line WL, or each gate electrode 312 may be the word line WL, as it is.

The insulating spacers 311 may include one of various insulating dielectric materials, for example, a silicon oxide, an aluminum oxide, a silicon nitride, and the like, but the disclosure is not limited thereto. The gate electrode 312 may include at least one of conductive materials, such as tungsten (W), molybdenum (Mo), ruthenium (Ru), polysilicon, TiN, and a two-dimensional metallic material, or a combination thereof. The two-dimensional metallic material may include at least one material, such as, graphene, TaS₂, TaSe₂, NbS₂, NbSe₂, PdTe₂, PtTe₂, NbTe₂, TiSe₂, VSe₂, AuSe, and MoTe₂. In some embodiments, although not illustrated, the gate electrodes 312 may include a gate layer (e.g., W, Mo, Ru, polysilicon) surrounded by a gate barrier layer (e.g., TiN, two-dimensional material such as graphene, but not limited thereto) covering at least one of a side surface, a lower surface, and an upper surface of the gate layer.

Furthermore, the memory cell string CS may include a channel hole that penetrates the insulating spacers 311 and the gate electrodes 312 in the first direction. A channel and a plurality of layers for forming resistance may be arranged in the channel hole. For example, the memory cell string CS may include an insulating support 324 arranged at a center of the channel hole and extending in the first direction, a resistance change layer 323 arranged to surround the insulating support 324 and extend in the first direction, a channel layer 322 arranged to surround the resistance change layer 323 and extend in the first direction, and a gate insulating film 321 arranged to surround the channel layer 322 and extend in the first direction. The gate insulating film 321 may be arranged between the channel layer 322 and the gate electrodes 312 and between the channel layer 322 and the insulating spacers 311.

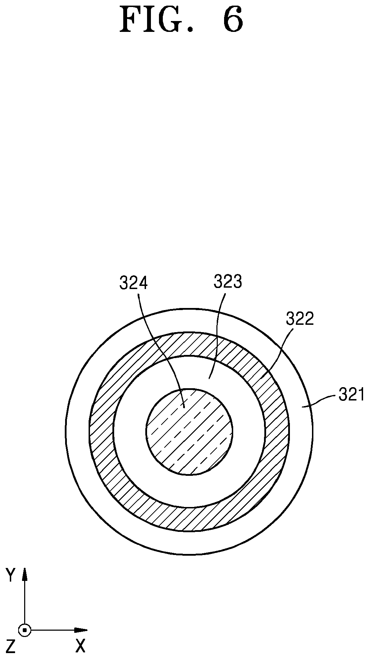

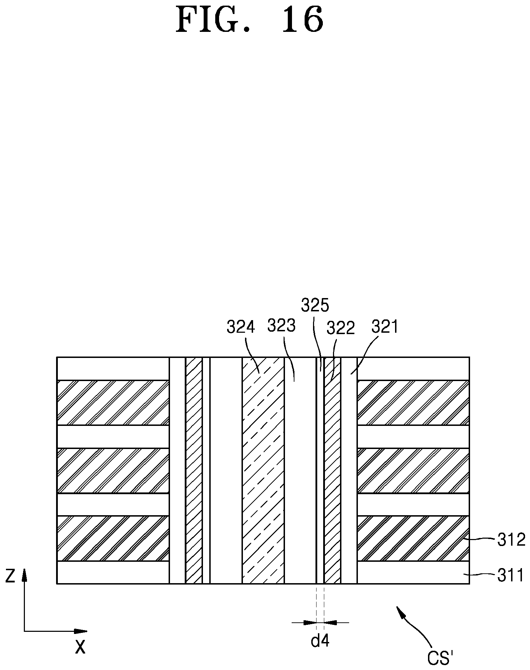

FIG. 6 is a schematic horizontal cross-sectional view showing a structure of the memory cell string CS according to an embodiment. Referring to FIG. 6, the insulating support 324, the resistance change layer 323, the channel layer 322, and the gate insulating film 321 may be sequentially arranged concentrically from the center. The gate insulating film 321 may have a cylindrical shape surrounding the channel layer 322, the channel layer 322 may have a cylindrical shape surrounding the resistance change layer 323, and the resistance change layer 323 may have a cylindrical shape surrounding the insulating support 324. Although not illustrated in FIG. 6, the insulating spacers 311 and the gate electrodes 312 may be alternatively stacked in the first direction while surrounding the gate insulating film 321. Although not illustrated in FIG. 6, a barrier layer (see barrier layer 325 in FIG. 16) may be concentrically arranged between the resistance change layer 323 and channel layer 322.

To this end, the gate insulating film 321 may be conformally deposited on the insulating spacers 311 and the gate electrodes 312 to extend in the first direction. The channel layer 322 may be conformally deposited along a surface of the gate insulating film 321 to extend in a vertical direction, that is, in the first direction. The resistance change layer 323 may be conformally deposited along the surface of the channel layer 322 to extend in the first direction. The insulating support 324 may be arranged to fill a remaining space in the center of the channel hole to extend in the first direction.

As a result, the resistance change layer 323 has a shape extending in the first direction facing the insulating spacers 311 and the gate electrodes 312, the channel layer 322 has a shape extending in the first direction between the resistance change layer 323 and the gate electrodes 312, and the gate insulating film 321 has a shape extending in the first direction between the channel layer 322 and the gate electrodes 312.

Although it is not illustrated, a drain may be arranged on the uppermost surface of the memory cell string CS to cover at least the channel layer 322. The drain may include a doped silicon material. The bit line BL may be connected to the drain.

The channel layer 322 may include, for example, polysilicon (poly-Si), but the disclosure is not limited thereto and the channel layer 322 may include various other conductive semiconductor materials. For example, the channel layer 322 may include a two-dimensional semiconductor material having a p type electrical characteristic. The channel layer 322 may include a two-dimensional semiconductor material of at least one of, for example, tellurene, black phosphorus, and WSe₂. Furthermore, the gate insulating film 321 and the insulating support 324 may include at least one of materials, for example, a silicon oxide (SiO), an aluminum oxide (AIO), a magnesium oxide (MgO), an aluminum nitride (AIN), a hafnium oxide (HfO), and a gallium nitride (GaN), but the disclosure is not limited thereto.

Referring back to FIG. 5, as indicated by a dashed box, any one gate electrode 312, and a portion of the gate insulating film 321, a portion of the channel layer 322, and a portion of the resistance change layer 323, which are adjacent to one another in the horizontal direction, that is, the second direction, with respect to the one gate electrode 312, are components of one memory cell MC. In particular, the one gate electrode 312, and the portion of the gate insulating film 321 and the portion of the channel layer 322, which are adjacent to the one gate electrode 312 in the horizontal direction, may form a transistor, and the portion of the resistance change layer 323 may form a resistor. Accordingly, each of the memory cells MCs may correspond to a circuit in which a transistor and a resistor are connected to each other in parallel. As the memory cells MCs are arranged in a vertical stack structure, the respective memory cell strings CS may be formed. The thickness of one of the memory cells MCs may be determined based on a first direction height t1 of one gate electrode 312, and an interval between the two memory cells MCs adjacent to each other in the first direction may be determined by a first direction height t2 of one of the insulating spacers 311. A degree of integration of the memory cell MC may be increased by reducing the first direction height t1 of the one gate electrode 312 and the first direction height t2 of the one insulating spacer 311. For example, the first direction height t1 of the one gate electrode 312 may be about 20 nm or less, and the first direction height t2 of the one insulating spacer 311 may be about 20 nm or less.

A second-direction thickness d1 of the gate insulating film 321 may be, for example, about 5 nm to about 50 nm. A second-direction thickness d2 of the channel layer 322 may be, for example, about 2.5 nm to about 20 nm. Furthermore, a second-direction thickness d3 of the resistance change layer 323 may be, for example, about 5 nm to about 100 nm, or about 5 nm to about 40 nm.

According to an embodiment, the resistance change layer 323 may include a material having Ovonic threshold switching (OTS) characteristics, by which, when a voltage less than a threshold voltage is applied, the resistance change layer 323 turns to a high resistance state and, when a voltage greater than the threshold voltage is applied, the resistance change layer 323 turns to a low resistance state. Furthermore, the resistance change layer 323 may have characteristics by which the threshold voltage is shifted according to the polarity and intensity of an applied bias voltage. For example, the resistance change layer 323 may be switched between a first state of having a first threshold voltage that is relatively low and a second state of having a second threshold voltage that is greater than the first threshold voltage. To this end, the resistance change layer 323 may include amorphous multi-component chalcogenide material. The resistance change layer 323 may have a single layer structure including at least one materials among, for example, GeAsSe, GeAsSeln, GeAsSeSln, GeAsSeSb, GeAsSeSbln, GeAsSeTe, GeAsSeTeln, GeAsSeAl, GeAsSeAlln, GeSbSe, GeSbSeln, GeSbSeN, GeSbSeNln, CTe, GeCTe, NGeCTe, BTe, SiTe, GeAsTe, GeSbSe, and GeSbSeN.

When the resistance change layer 323 includes germanium (Ge), a ratio of Ge in the resistance change layer 323 may be about 10 at% to about 30 at%. When the resistance change layer 323 includes arsenic (As), a ratio of As in the resistance change layer 323 may be about 10 at% to about 50 at%, and when the resistance change layer 323 includes selenium (Se), a ratio of Se in the resistance change layer 323 may be about 40 at% to about 80 at%. Furthermore, when the resistance change layer 323 includes indium (In), a ratio of In in the resistance change layer 323 may be about 1 at% to about 10 at%, about 1 at% to about 8 at%, or about 3 at% to about 5 at%. The ratio of a particular element (e.g., Ge, As, Se) in the resistance change layer 323 may refer to a ratio of the particular element to all elements in the resistance change layer 323. In other words, for GeAsSe, a ratio of Ge may refer to amount of Ge compared to a total amount of Ge, As, and Se in combination.

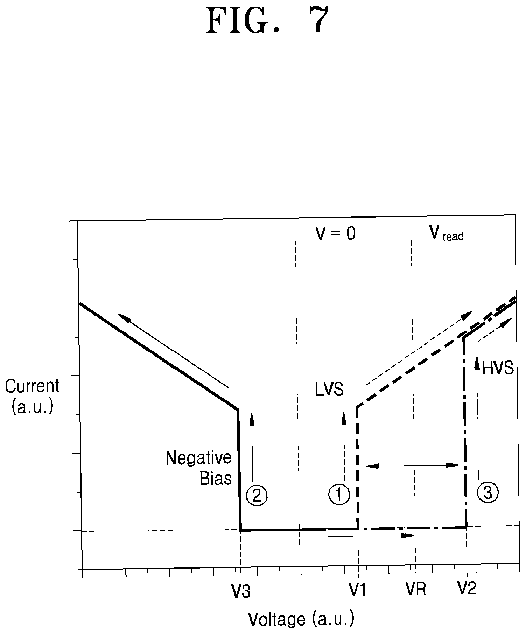

FIG. 7 is a graph showing an example of voltage-current characteristics of the resistance change layer 323 of the memory cell string CS according to an embodiment. Referring to FIG. 7, the resistance change layer 323 may have any one state of a first state (low Vth state; LVS) in which a threshold voltage is relatively low and a second state (high Vth state; HVS) in which the threshold voltage is relatively high. For example, in the first state, the first threshold voltage of the resistance change layer 323 may be a first voltage V1, and in the second state, the second threshold voltage of the resistance change layer 323 may be a second voltage V2 that is greater than the first voltage V1. When the resistance change layer 323 is in the first state and a voltage less than the first voltage V1 is applied to the resistance change layer 323, a current hardly flows in the resistance change layer 323, and when a voltage greater than or equal to the first voltage V1 is applied to the resistance change layer 323, the resistance change layer 323 is turned on so that a current flows through the resistance change layer 323. Furthermore, when the resistance change layer 323 is in the second state and a voltage less than the second voltage V2, which is the second threshold voltage, is applied to the resistance change layer 323, a current hardly flows in the resistance change layer 323, and when a voltage greater than or equal to the second voltage V2 is applied to the resistance change layer 323, the resistance change layer 323 is turned on so that a current flows through the resistance change layer 323.

Accordingly, a voltage in a range between the first voltage V1 and the second voltage V2 may be selected as a read voltage VR. When the resistance change layer 323 is in the first state and the read voltage VR is applied to the resistance change layer 323, a current may flow through the resistance change layer 323, and in this state, a data value stored in the resistance change layer 323 may be defined as "1". When the resistance change layer 323 is in the second state and the read voltage VR is applied to the resistance change layer 323, a current hardly flows through the resistance change layer 323, and in this state, the data value stored in the resistance change layer 323 may be defined as "0". In other words, while the read voltage VR is applied to the resistance change layer 323, when a current flowing in the resistance change layer 323 is measured, the data value stored in the resistance change layer 323 may be read.

Meantime, when the resistance change layer 323 is in the first state and a negative (-) bias voltage is applied to the resistance change layer 323, the threshold voltage of the resistance change layer 323 increases so that the resistance change layer 323 may be switched to the second state. For example, when a negative third voltage V3 is applied to the resistance change layer 323, the resistance change layer 323 may be switched to the second state. Such an operation may be referred to as a "RESET" operation. Furthermore, when the resistance change layer 323 is in the second state and a positive (+) bias voltage greater than the second voltage V2 is applied to the resistance change layer 323, the threshold voltage of the resistance change layer 323 decreases so that the resistance change layer 323 may be switched to the first state. Such an operation may be referred to as a "SET" operation.

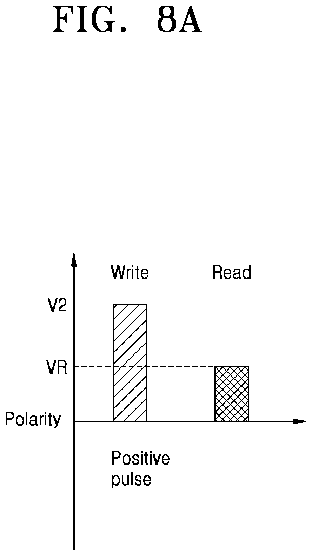

FIG. 8A is a graph showing an example of a bias voltage for a SET operation and a read operation in the resistance change layer 323 of the memory cell string CS according to an embodiment Referring to FIG. 8A, in a SET operation, a positive bias voltage greater than or equal to the second voltage V2 may be applied to the resistance change layer 323. Then, the threshold voltage of the resistance change layer 323 may be shifted to the first voltage V1. Then, in the read operation, a positive read voltage VR between the first voltage V1 and the second voltage V2 may be applied to the resistance change layer 323. When the read voltage VR is applied, the resistance change layer 323 may be turned on.

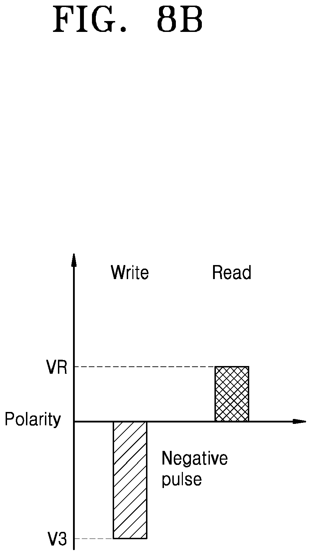

FIG. 8B is a graph showing an example of a bias voltage for a RESET operation and a read operation in the resistance change layer 323 of the memory cell string CS according to an embodiment. Referring to FIG. 8B, in a RESET operation, a negative bias voltage, that is, a third voltage V3 may be applied to the resistance change layer 323. The absolute value of the third voltage V3 may be approximately equal to or slightly greater or less than the second voltage V2. Then, the threshold voltage of the resistance change layer 323 may be shifted to the second voltage V2 that is greater than the first voltage V1. Then, in the read operation, a positive read voltage VR between the first voltage V1 and the second voltage V2 may be applied to the resistance change layer 323. When the read voltage VR is applied, the resistance change layer 323 may be turned off.

As such, the resistance change layer 323 including an amorphous multi-component chalcogenide material having the composition described above may have Ovonic threshold switching characteristics and simultaneously memory characteristics in which the threshold voltage changes. In particular, the threshold voltage of the resistance change layer 323 may be shifted according to the polarity of the bias voltage applied to the resistance change layer 323. In this regard, it may be seen that the resistance change layer 323 according to an embodiment may have polarity-dependent threshold voltage shift characteristics.

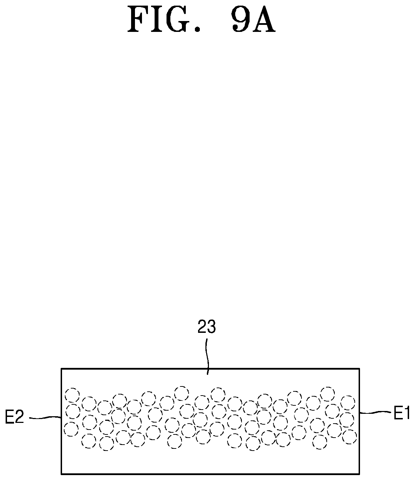

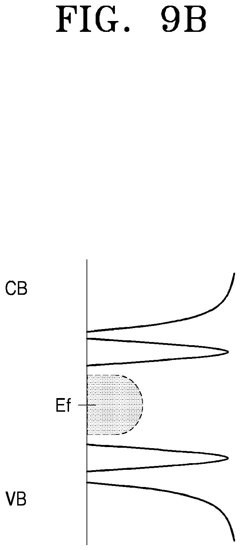

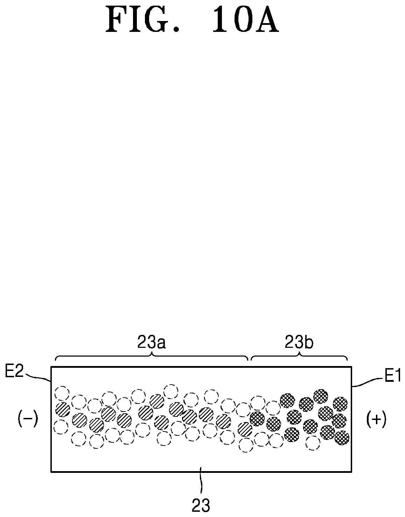

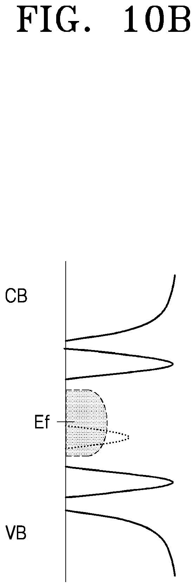

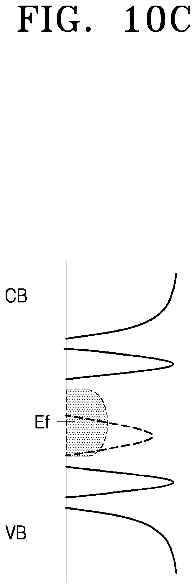

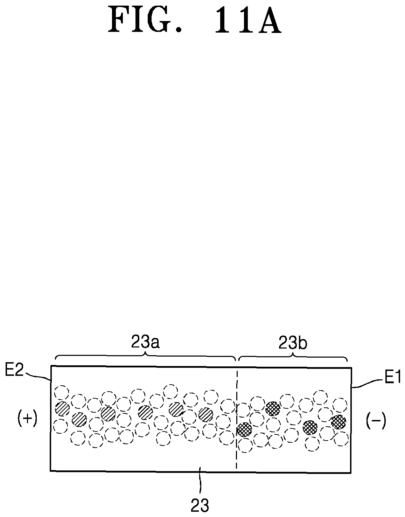

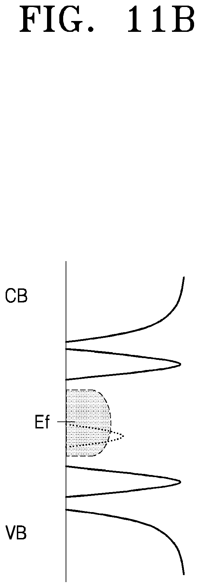

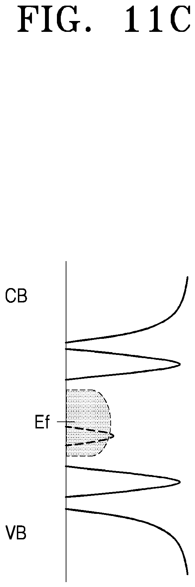

The polarity-dependent threshold voltage shift behavior may be described through a change in a trap state in the material of the resistance change layer 323. FIGS. 9A to 11C are view for describing the concept of a change in a trap state in the material of the resistance change layer 323. In particular, FIG. 9A is a conceptual view showing an example of a trap state in a resistance change layer material 23 when the resistance change layer material 23 is in a pristine state, and FIG. 9B is a schematic energy band diagram of the resistance change layer material 23 in the pristine state. FIG. 10A is a conceptual view showing an example of a trap state in the resistance change layer material 23 after a positive (+) bias voltage for first-firing is applied to the resistance change layer material 23 in a pristine state, FIG. 10B is a schematic energy band diagram of the resistance change layer material 23 around a first end portion after the first-firing, and FIG. 10C is a schematic energy band diagram of the resistance change layer material 23 around a second end portion after the first-firing FIG. 11A is a conceptual view showing an example of a trap state in the resistance change layer material 23 after a negative (-) bias voltage is applied to the first-fired resistance change layer material 23, FIG. 11B is a schematic energy band diagram of the resistance change layer material 23 around the first end portion after the application of the negative bias voltage, and FIG. 11C is a schematic energy band diagram of the resistance change layer material 23 around the second end portion after the application of the negative bias voltage

Referring to FIG. 9A, de-activated traps are mainly present inside the resistance change layer material 23 in a pristine state just after being manufactured. For convenience of explanation, in FIG. 9A, the de-activated traps are indicated by dashed circles. For example, the de-activated traps may be mainly formed by covalent bonds (Se-Se) between Se atoms neighboring each other in the resistance change layer material 23.

Furthermore, in the graph of FIG. 9B, "CB" denotes a conduction band, "VB" denotes a valence band, and a horizontal axis direction denotes a density of state. Referring to FIG. 9B, an energy band formed by the de-activated traps is indicated by a thin dashed line. In FIG. 9B, the energy band indicated by a solid line is formed by materials other than Se in the resistance change layer material 23. The energy band formed by the de-activated traps may be distributed around the Fermi level Ef.

In order to first-fire the resistance change layer material 23 in a pristine state, a positive (+) bias voltage may be applied to the resistance change layer material 23. For example, a bias voltage may be applied to the resistance change layer material 23 so that a current flows from a first end portion E1 to a second end portion E2 of the resistance change layer material 23. Referring to FIG. 10A, activated traps may be formed as some of the de-activated traps are activated by the first-firing. The activated traps may be mainly formed by selenium ions Se²⁻ that are generated as the covalent bond between the Se atoms are broken. These activated traps may form a percolation path in the resistance change layer material 23, and as the percolation path is formed, the threshold voltage of the resistance change layer material 23 may be decreased.

In FIG. 10A, the activated traps are indicated by hatch pattern circles and mesh pattern circles. As illustrated in FIG. 10A, the amount of the activated traps in the resistance change layer material 23 may increase from the second end portion E2 to the first end portion E1. In particular, the activated traps may be generated in a large amount in a region of the resistance change layer material 23 close to the first end portion E1. Accordingly, after the first-firing, the resistance change layer material 23 may include a first region 23a in which the density of activated traps is relatively low and a second region 23b in which the density of activated traps is relatively high. The length of the second region 23b may be less than the length of the first region 23a. For example, the length of the first region 23a may be two times to ten times the length of the second region 23b.

The first region 23a is an region adjacent to the second end portion E2 to which the negative (-) voltage is applied during the first-firing. The activated traps in the first region 23a are indicated by hatch pattern circles In the first region 23a, the density of activated traps may slightly increase toward a boundary with the second region 23b, but the amount of increase may be relatively small. The second region 23b is a region adjacent to the first end portion E1 to which the positive (+) voltage is applied during the first-firing. Furthermore, the second region 23b may be in direct contact with the first region 23a and arranged between the first region 23a and the first end portion E1. The activated traps in the second region 23b may be indicated by mesh pattern circles. In the second region 23b, the density of activated traps may relatively greatly increase close to the first end portion E1. Accordingly, the density of activated traps in the second region 23b may be greater than the density of activated traps in the first region 23a. In this case, the resistance change layer material 23 may be in the first state in which the threshold voltage is relatively low. In other words, when the resistance change layer material 23 is in the first state, the density of activated traps in the second region 23b is greater than the density of activated traps in the first region 23a.

Referring to FIG. 10B, the energy band formed by the activated traps in the first region 23a are indicated by dotted line. The energy band formed by the activated traps may be located at an energy level that is slightly less than the Fermi level Ef. Furthermore, referring to FIG. 10C, in the second region 23b, the energy band formed by the activated traps is indicated by a thick dashed line. Comparing FIG. 10B with FIG. 10C, it may be seen that the energy band formed by the activated traps in the second region 23b has an energy distribution slightly larger than the energy band formed by the activated traps in the first region 23a. Furthermore, it may be seen that the density of state of activated traps in the second region 23b is greater than the density of state of activated traps in the first region 23a. Accordingly, it may be seen that the amount of activated traps in the second region 23b is greater than the amount of activated traps in the first region 23a.

The high activated trap density around the first end portion E1 after the first-firing may have a great effect on the threshold voltage shift behavior of the resistance change layer material 23. For example, the density of activated traps in the second region 23b may be relatively easily changed according to the polarity of the bias voltage, and thus, the threshold voltage of the resistance change layer material 23 may be relatively easily shifted.

When a negative (-) bias voltage is applied to the resistance change layer material 23 that is first-fired, that is, a bias voltage is applied to the resistance change layer material 23 in the reverse direction so that a current flows from the second end portion E2 to the first end portion E1, some of the activated traps in the second region 23b close to the first end portion E1 are annihilated and turned to de-activated traps. This may be described as the selenium ions Se²⁻ neighboring each other being recombined to each other to thus form a covalent bond (Se-Se). As a result, the density of activated traps in the resistance change layer material 23 is decreased.

Comparing FIG. 10A with FIG. 11A, after a negative bias voltage is applied to the resistance change layer material 23, the density of activated traps may be decreased in both the first region 23a and the second region 23b. In particular, the density of activated traps may be decreased even further in the second region 23b. In contrast, the amount of change in the density of activated traps in the first region 23a may be less than the amount of change in the density of activated traps in the second region 23b. Accordingly, after a negative bias voltage is applied to the resistance change layer material 23, the density of activated traps in the second region 23b may be less than the density of activated traps in the first region 23a. Accordingly, an interface tunneling barrier (ITB) may be formed the boundary between the first region 23a and the second region 23b.

Furthermore, comparing FIG. 10B with FIG. 11B, after a negative bias voltage is applied to the resistance change layer material 23, the density of state of activated traps in the first region 23a may be slightly decreased. In contrast, comparing FIG. 10C with FIG. 11C, after a negative bias voltage is applied to the resistance change layer material 23, the density of state of activated traps in the second region 23b may be relatively greatly decreased. Furthermore, comparing FIG. 11B with FIG. 11C, after a negative bias voltage is applied to the resistance change layer material 23, it may be seen that the density of state of activated traps in the second region 23b is less than the density of state of activated traps in the first region 23a.

When the amount of activated traps decreases in the resistance change layer material 23, in particular, in the second region 23b close to the first end portion E1, a relatively great bias voltage is need to form an electrical conduction path, and thus, the threshold voltage of the resistance change layer material 23 may be increased. In this state, the resistance change layer material 23 may be in the second state in which the threshold voltage is relatively high. In other words, when the resistance change layer material 23 is in the second state, the density of activated traps in the second region 23b may be less than the density of activated traps in the first region 23a. Furthermore, the density of activated traps in the first region 23a and the density of activated traps in the second region 23b when the resistance change layer material 23 is in the second state may be respectively less than the density of activated traps in the first region 23a and the density of activated traps in the second region 23b when the resistance change layer material 23 is in the first state.

Then, when a positive bias voltage greater than or equal to the threshold voltage is applied to the resistance change layer material 23, the amount of activated traps increases in the resistance change layer material 23, in particular, in the second region 23b, and thus, the threshold voltage of the resistance change layer material 23 may be decreased again. Then, the resistance change layer material 23 may be turned back to the first state. As such, through the change in the state of activated traps in the resistance change layer material 23, in particular, a great change in the state of activated traps in the second region 23b close to the first end portion E1, the threshold voltage shift behavior may be implemented. As the density of activated traps in the pristine state is less than the density of activated traps in a state of applying a negative bias voltage after the first-firing, a positive bias voltage needed for the first-firing may be greater than the positive bias voltage to reduce the threshold voltage of the resistance change layer material 23 after the application of a negative bias voltage.

As described above, the threshold voltage shift in the resistance change layer material 23 may occur not by an ion movement phenomenon, but by a change in the state of activated traps or a change in the density of activated traps. Accordingly, a change in the composition in the resistance change layer material 23 hardly occurs in a state before the first-firing, a state after the first-firing, and a state of a negative bias voltage being applied after the first-firing, and thus, an element composition distribution in the resistance change layer material 23 may be maintained substantially constant. The expression that the element composition distribution is "maintained constant" may mean that there is no meaningful change in the concentration of each element included in the resistance change layer material 23, for example, the first region 23a and the second region 23b of the resistance change layer material 23. Specifically, the expression that the element composition distribution is "maintained constant" may include a case in which a difference in the concentrations of the respective elements included in the first region 23a and the second region 23b of the resistance change layer material 23 when the resistance change layer material 23 is in the first state and the second state is within 10%.

In other words, when the resistance change layer material 23 is changed from the first state to the second state or from the second state to the first state, a ratio of elements, such as Ge, As, Se, and the like, in the first region 23a and the second region 23b of the resistance change layer material 23 may be maintained constant. For example, when the resistance change layer material 23 includes Se, there hardly is a difference between a selenium concentration in the first region 23a when the resistance change layer material 23 is in the first state and the selenium concentration in the first region 23a when the resistance change layer material 23 is in the second state.

When the resistance change layer material 23 including an amorphous multi-component chalcogenide material having the composition described above is used as the resistance change layer 323 of the memory cell string CS, the memory device 200 may have a relatively fast driving speed. For example, the resistance change layer 323 including an amorphous multi-component chalcogenide material having the composition described above is capable of threshold voltage switching even when a voltage having a pulse width of about 1 nsec or less is applied thereto. Accordingly, the memory device 200 may have a relatively fast driving speed of, for example, about 1 nsec or less.

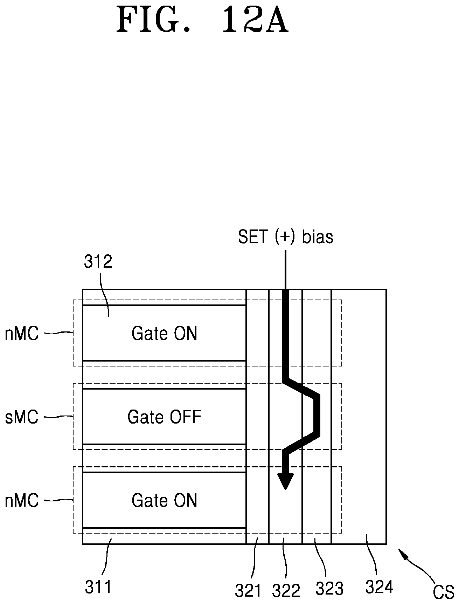

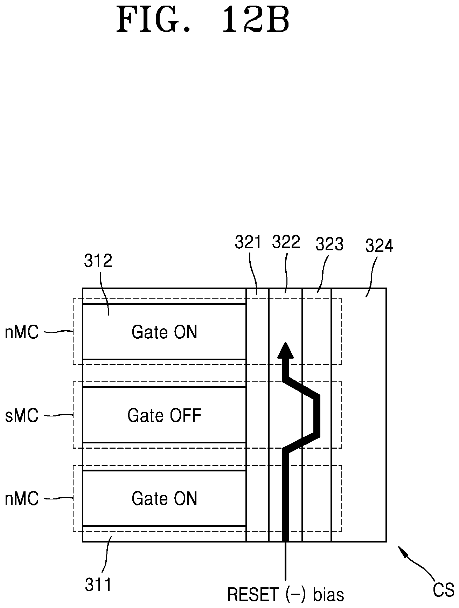

In the memory cell string CS including the resistance change layer 323 having the characteristics described above, the SET operation and the RESET operation may be independently performed for each of the memory cells MCs of the memory cell string CS. FIG. 12A illustrates an example of the SET operation of the memory cell string CS according to an embodiment, and FIG. 12B schematically shows an example of the RESET operation of the memory cell string CS according to an embodiment.

Referring to FIG. 12A, a gate voltage less than a threshold voltage may be applied, through the word line WL, to the gate electrode 312 of a selected memory cell sMC on which a SET operation is to be performed. Alternatively, the gate voltage may not be applied thereto. Here, the threshold voltage refers to a threshold voltage of a transistor formed by one gate electrode 312, and a portion of the gate insulating film 321 and a portion of the channel layer 322, which are adjacent to the gate electrode 312 in the horizontal direction (e.g., the second direction or the third direction). A gate voltage greater than or equal to the threshold voltage may be applied, through the word line WL, to the gate electrodes 312 of all the other non-selected memory cells nMCs on which the SET operation is not performed. Accordingly, the transistors of the non-selected memory cells nMCs are all turned on so that a current may flow through the channel layers 322 of the non-selected memory cells nMCs, and the transistor of the selected memory cell sMC is turned off so that no current flows through the channel layer 322 of the selected memory cell sMC.

A positive (+) bias voltage greater than the second voltage V2 described in FIGS. 7 and 8A may be applied to the channel layer 322 through the bit line BL. Then, in the non-selected memory cell nMC, most of the current flows through the channel layer 322, and in the selected memory cell sMC, most of the current flows through the resistance change layer 323. Accordingly, a partial region of the resistance change layer 323 in the selected memory cell sMC may be switched to the first state. Among the entire resistance change layer 323 of the memory cell string CS, only a portion in the selected memory cell sMC may be switched to the first state. In other words, only a partial region of the entire resistance change layer 323 adjacent in the horizontal direction to the gate electrode 312 to which the gate voltage less than a threshold voltage is applied, may be switched to the first state.

Referring to FIG. 12B, while a gate voltage less than a threshold voltage may be applied to the gate electrode 312 of the selected memory cell sMC on which a RESET operation is to be performed, a gate voltage greater than or equal to the threshold voltage may be applied to the gate electrodes 312 of all the other non-selected memory cells nMCs. The third voltage V3 or a negative (-) bias voltage less than the third voltage V3 may be applied to the channel layer 322 through the bit line BL. Then, a partial region of the resistance change layer 323 in the selected memory cell sMC may be switched to the second state.

A read operation may be performed by applying a positive read voltage VR between the first voltage V1 that is the first threshold voltage and the second voltage V2 that is the second threshold voltage to the channel layer 322, while a gate voltage less than a threshold voltage is being applied to the gate electrode 312 of the selected memory cell sMC only and a gate voltage greater than or equal is being applied to the threshold voltage to the gate electrodes 312 of all the non-selected memory cells nMCs.

Such a SET operation, a RESET operation, and a read operation may be performed after the resistance change layer 323 is first-fired. The first-firing may also be independently performed for each memory cell MC. In other words, after manufacturing the memory cell string CS, first-firing may be sequentially performed, one by one, on the memory cells MCs in the memory cell string CS. For example, while a gate voltage less than a threshold voltage is being applied to the gate electrode 312 of the selected memory cell sMC only and a gate voltage greater than or equal to the threshold voltage is being applied to the gate electrodes 312 of all the non-selected memory cells nMCs, a first-firing voltage greater than the positive bias voltage for a SET operation may be applied to the channel layer 322. First-firing may be performed by sequentially changing the selected memory cells sMCs until the regions of the resistance change layer 323 corresponding to all memory cells MCs in the memory cell string CS are first-fired.

After first-firing on all memory cells MCs in the memory cell string CS is completed, the region of the resistance change layer 323 between two memory cells MCs adjacent to each other in the vertical direction (e.g., first direction) may remain in the pristine state. In other words, while only a partial region of the resistance change layer 323 adjacent to the gate electrode 312 in the second direction or the third direction is in a first-fired state, a partial region of the resistance change layer 323 adjacent to the insulating spacers 311 in the second direction or the third direction may remain in the pristine state. Accordingly, in one memory cell string CS, the resistance change layer 323 may have a plurality of driving regions and a plurality of pristine-state regions in the vertical direction (e.g., the first direction).

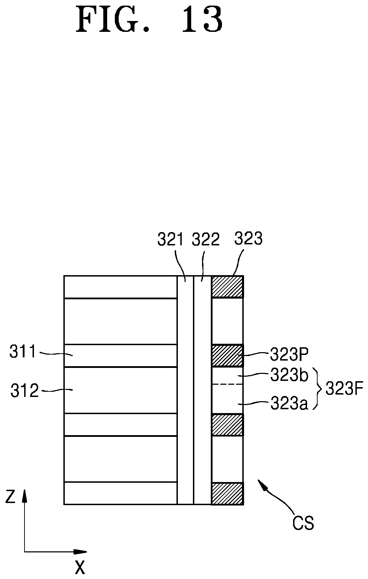

FIG. 13 illustrates an example of regions formed in the resistance change layer 323 after the first-firing of a memory cell string according to an embodiment. Referring to FIG. 13, the resistance change layer 323 in one memory cell string CS may include a plurality of driving regions 323F and a plurality of pristine-state regions 323P, which are alternately provided in first direction. Each of the driving regions 323F may be provided to face any corresponding one of the gate electrodes 312 in the second direction, and each of the pristine-state regions 323P may be provided to face any corresponding one of the insulating spacers 311 in the second direction. The concentration of activated traps in the pristine-state regions 323P may be less than the concentration of activated traps in the driving regions 323F. Furthermore, when a voltage greater than or equal to the first threshold voltage is applied to the resistance change layer 323, the resistance of each of the pristine-state regions 323P may be greater than that of each of the driving regions 323F.

As described in FIG. 10A, each of the driving regions 323F may include a first region 323a and a second region 323b, both having different densities of activated traps. The length or thickness of the second region 323b in the first direction may be less than the length or thickness of the first region 323a in the first direction. For example, the length or thickness of the first region 323a in the first direction may be 2 times to 10 times the length or thickness of the second region 323b in the first direction. When the driving regions 323F of the resistance change layer 323 are in the first state, the density of activated traps in the second region 323b is greater than the density of activated traps in the first region 323a. In contrast, when the driving regions 323F of the resistance change layer 323 are in the second state, the density of activated traps in the second region 323b may be less than the density of activated traps in the first region 323a. Furthermore, the density of activated traps in the first region 323a and the density of activated traps in the second region 323b when the driving regions 323F of the resistance change layer 323 are in the second state may be respectively less than the density of activated traps in the first region 323a and the density of activated traps in the second region 323b when the driving regions 323F of the resistance change layer 323 is in the first state.

Furthermore, as described above, in the pristine-state regions 323P, the first region 323a of the driving regions 323F, and the second region 323b of the driving regions 323F, a change in the element composition in the resistance change layer 323 may hardly occur. Accordingly, an element composition distribution in the pristine-state regions 323P, the first region 323a, and the second region 323b may be substantially the same.

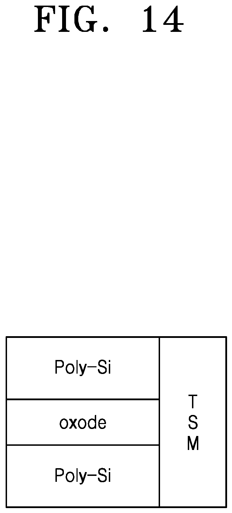

FIG. 14 is a vertical cross-sectional view showing a structure manufactured to check an actual operation of the memory cell string CS according to an embodiment. Referring to FIG. 14, layers of polysilicon, silicon oxide, and polysilicon are sequentially stacked in the first direction, and a threshold switching memory material (TSM) is formed along the side walls of the stacked polysilicon, silicon oxide, and polysilicon. The two polysilicon may correspond to the channels of the non-selected memory cells nMCs, and the silicon oxide may correspond to the channel of the selected memory cell sMC. The threshold switching memory material TSM may correspond to the resistance change layer 323, and may include the material of the resistance change layer 323 described above. In the structure of FIG. 14, the first-firing voltage, the RESET voltage, and the SET voltage are sequentially applied to the polysilicon.

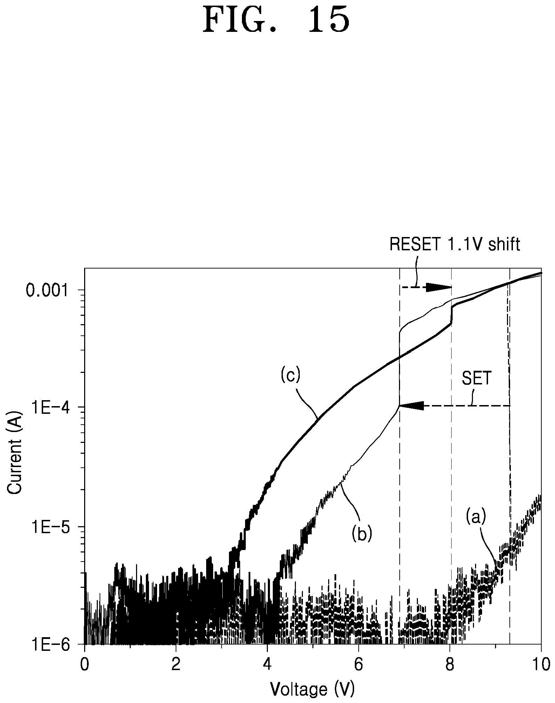

FIG. 15 is a graph showing an example of the voltage-current characteristics of the structure of FIG. 14 in a pristine state, a SET state, and a RESET state. In FIG. 15, graph (a) shows voltage-current characteristics in a pristine state, graph (b) shows voltage-current characteristics in a SET state, and graph(c) shows voltage-current characteristics in a RESET state. Referring to FIG. 15, in the pristine state, the resistance of the threshold switching memory material TSM is the highest and no threshold voltage is observed. After the first-firing, the resistance of the threshold switching memory material TSM decreases. In the SET state, a threshold voltage at which a current suddenly increases is observed at about 6.9 V. In the RESET state, a threshold voltage at which a current suddenly increases is observed at about 8 V. At an applied voltage between about 6.9 V and about 8 V, the resistance of the threshold switching memory material TSM in the SET state is less than the resistance of the threshold switching memory material TSM in the RESET state. Accordingly, in an example illustrated in FIG. 15, it may be seen that the first voltage V1 that is the first threshold voltage is about 6.9V and the second voltage V2 that is the second threshold voltage is about 8 V.

FIG. 16 is a schematic vertical cross-sectional view showing a structure of a memory cell string CS' according to another embodiment. Referring to FIG. 16, the memory cell string CS' according to another embodiment may further include a barrier layer 325 provided between the channel layer 322 and the resistance change layer 323. The barrier layer 325 may be conformally deposited along the surface of the channel layer 322 to extend in the first direction, and the resistance change layer 323 may be conformally deposited along the surface of the barrier layer 325 to extend in the vertical direction. The barrier layer 325 may limit and/or prevent diffusion of materials between the channel layer 322 and the resistance change layer 323. The barrier layer 325 may include a carbon- or nitrogen-based insulator. For example, the barrier layer 325 may include at least one material of C, CN, and SiN. However, in the case where the material of the resistance change layer 323 is unlikely to oxidize when the resistance change layer 323 is formed along the surface of the barrier layer 325, the barrier layer 325 may include an oxide such as Al₂O₃. In order to limit and/or minimize power loss by the barrier layer 325, the barrier layer 325 may be formed as thin as possible. For example, a second-direction thickness d4 of the barrier layer 325 may be greater than 0 nm and about 10 nm or less.

As described above, the memory device 200 according to an embodiment having characteristics of a voltage driving device may operate similar to a charge trap flash (CTF)-VNAND. Furthermore, the memory device 200 according to an embodiment may have a relatively fast driving speed. In particular, the memory device 200 according to an embodiment may have high reliability because there hardly is an interference between the memory cells MCs adjacent to each other in the memory cell string CS. For example, as the resistance change layer 323 includes the pristine-state regions 323P having the lowest concentration of activated traps between the memory cells MCs adjacent to each other, interference may hardly occur between the two driving regions 323F adjacent to each other in the first direction. Accordingly, as the interval between the adjacent memory cells MCs, that is, the thickness (or height in the first direction) of the insulating spacers 311 may be reduced, the memory device 200 may be manufactured with a high degree of integration, and thus, the capacity of the memory device 200 may be improved.

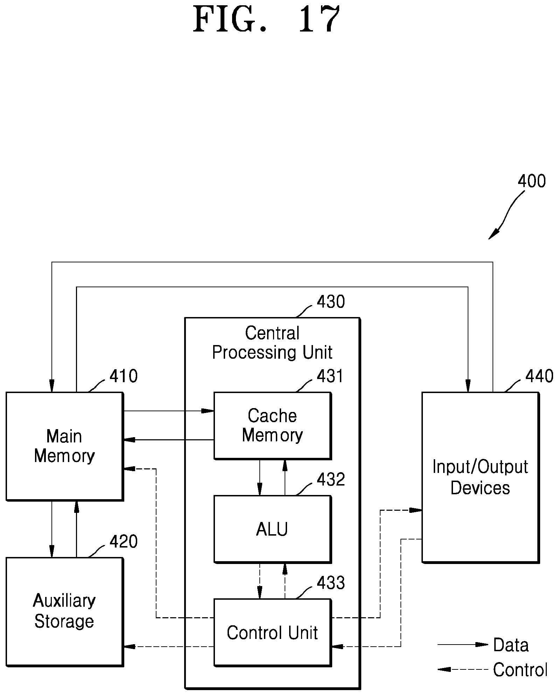

The memory device 200 described above may be used to store data in various electronic devices. FIG. 17 is a schematic conceptual view of a device architecture applicable to an electronic device 400 including a memory device according to embodiments. Referring to FIG. 17, the electronic device 400 may include a main memory 410, an auxiliary storage 420, a central processing unit (CPU) 430, and an input/output device 440. The CPU 430 may include a cache memory 431, an arithmetic logic unit (ALU) 432, and a control unit 433. The cache memory 431 may include a static random access memory (SRAM). The main memory 410 may include a DRAM device, and the auxiliary storage 420 may include the memory device 200 according to an embodiment. Alternatively, the cache memory 431, the main memory 410, and the auxiliary storage 420 may all include the memory device 100 or 200 according to an embodiment. In some cases, the electronic device 400 may be implemented in the form of computing unit devices and memory unit devices being adjacent to each other in one chip, without distinction of the sub-units described above.

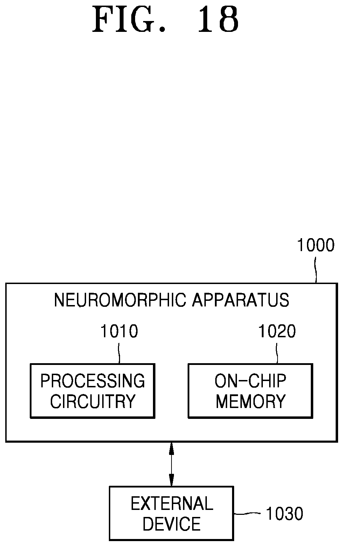

Furthermore, the memory device 200 may be used as a neuromorphic computing platform. For example, FIG. 18 is a schematic block diagram of a neuromorphic apparatus 1000 including the memory device 200 according to an embodiment. Referring to FIG. 18, the neuromorphic apparatus 1000 may include a processing circuitry 1010 and/or a memory 1020. The memory 1020 of the neuromorphic apparatus 1000 may include the memory device 200 according to an embodiment.

The processing circuitry 1010 may be configured to control functions to drive the neuromorphic apparatus 1000. For example, the processing circuitry 1010 may be configured to control the neuromorphic apparatus 1000 by executing a program stored in the memory 1020 of the neuromorphic apparatus 1000. The processing circuitry 1010 may include hardware such as a logic circuit, a combination of hardware such as logic circuits; a hardware/software combination, such as a processor executing software; or a combination thereof. For example, the processor may include a CPU, a graphics processing unit (GPU), an application processor (AP) included in the neuromorphic apparatus 1000, an arithmetic logic unit (ALU), a digital processor, a microcomputer, a field programmable gate array (FPGA), a system-on-chip (SoC), a programmable logic unit, a microprocessor, an application-specific integrated circuit (ASIC), and the like. Furthermore, the processing circuitry 1010 may be configured to read and write various pieces of data from/in an external device 1030 and execute the neuromorphic apparatus 1000 by using the data. The external device 1030 may include a sensor array including an external memory and/or an image sensor (e.g., a CMOS image sensor circuit).

The neuromorphic apparatus 1000 of FIG. 18 may be applied to a machine learning system. Such machine learning systems may utilize various artificial neural network organizational and processing models, such as convolutional neural networks (CNN), de-convolutional neural networks, recurrent neural networks (RNN) optionally including long short-term memory (LSTM) units and/or gated recurrent units (GRU), stacked neural networks (SNN), state-space dynamic neural networks (SSDNN), deep belief networks (DBN), generative adversarial networks (GANs), and/or restricted Boltzmann machines (RBM).

Such machine learning systems may include other forms of machine learning models, such as, for example, linear and/or logistic regression, statistical clustering, Bayesian classification, decision trees, dimensionality reduction such as principal component analysis, and expert systems; and/or combinations thereof, including ensembles such as random forests. Such machine learning models may be used to provide various services, for example, an image classify service, a user authentication service based on bio-information or biometric data, an advanced driver assistance system (ADAS) service, a voice assistant service, an automatic speech recognition (ASR) service, or the like, and may be mounted and executed by other electronic devices.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), a graphics processing unit (GPU), an application processor (AP) an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that the vertical non-volatile memory device including a memory cell string described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. A vertical non-volatile memory device comprising:
a plurality of memory cell strings arranged two-dimensionally, wherein
each of the plurality of memory cell strings includes
a channel layer extending in a first direction,
a plurality of gate electrodes and a plurality of spacers alternately arranged in the first direction and each extending in a second direction, the second direction crossing the first direction,
a gate insulating film extending in the first direction and between the channel layer and the plurality of gate electrodes, and
a resistance change layer extending in the first direction along a surface of the channel layer,
a material in the resistance change layer is capable of switching between a first state having a first threshold voltage and a second state having a second threshold voltage, and
the second threshold voltage is greater than the first threshold voltage.

2. The vertical non-volatile memory device of claim 1, wherein
no current flows in the resistance change layer if the resistance change layer is in the first state and a voltage less than the first threshold voltage is applied to the resistance change layer,
current flows in the resistance change layer if the resistance change layer is in the first state and a voltage greater than or equal to the first threshold voltage is applied to the resistance change layer,
no current flows in the resistance change layer if the resistance change layer is in the second state and a voltage less than the second threshold voltage is applied to the resistance change layer, and
current flows in the resistance change layer if the resistance change layer is in the second state and a voltage greater than or equal to the second threshold voltage is applied to the resistance change layer.

3. The vertical non-volatile memory device of claim 2, wherein
the resistance change layer is configured to switch from the first state to the second state in response to the resistance change layer being in the first state while a sufficient negative (-) bias voltage is applied to the resistance change layer, and
the resistance change layer is configured to switch from the first state to the second state in response to the resistance change layer being in the second state while a positive (+) bias voltage greater than the second threshold voltage is applied to the resistance change layer.

4. The vertical non-volatile memory device of any preceding claim, wherein the non-volatile memory device is configured to perform a read operation that includes applying a read voltage between the first threshold voltage and the second threshold voltage to the resistance change layer.

5. The vertical non-volatile memory device of any preceding claim, wherein the resistance change layer has a single layer structure including at least one amorphous multi-component chalcogenide material among GeAsSe, GeAsSeln, GeAsSeSln, GeAsSeSb, GeAsSeSbln, GeAsSeTe, GeAsSeTeln, GeAsSeAl, GeAsSeAlln, GeSbSe, GeSbSeln, GeSbSeN, GeSbSeNln, CTe, GeCTe, NGeCTe, BTe, SiTe, GeAsTe, GeSbSe, and GeSbSeN, and optionally wherein at least one of: a ratio of germanium (Ge) in the resistance change layer is 10 at% to 30 at%; a ratio of arsenic (As) in the resistance change layer is 10 at% to 50 at%; and a ratio of selenium (Se) in the resistance change layer is 40 at% to 80 at%.

6. The vertical non-volatile memory device of claim 5, wherein a ratio of indium (In) in the resistance change layer is 1 at% to 10 at%.

7. The vertical non-volatile memory device of any preceding claim, wherein
the resistance change layer comprises a plurality of driving regions and a plurality of pristine-state regions alternately arranged in the first direction, and optionally wherein:
each of the plurality of driving regions faces a corresponding gate electrode of the plurality of gate electrodes in the second direction; and
each of the plurality of pristine-state regions faces a corresponding spacer of the plurality of spacers in the second direction.

8. The vertical non-volatile memory device of claim 7, wherein
in response to a voltage greater than or equal to the first threshold voltage being applied to the resistance change layer, a resistance of the plurality of pristine-state regions is greater than a resistance of the plurality of driving regions.

9. The vertical non-volatile memory device of claim 7 or 8, wherein
each of the plurality of driving regions comprises a first region and a second region having different densities of activated traps, and optionally wherein:
if the resistance change layer is in the first state, a density of activated traps in the second region is greater than a density of activated traps in the first region; and
if the resistance change layer is in the second state, the density of activated traps in the second region is less than the density of activated traps in the first region.

10. The vertical non-volatile memory device of claim 9, wherein a thickness of the second region in the first direction is less than a thickness of the first region in the first direction.

11. The vertical non-volatile memory device of claim 9 or 10, wherein a thickness of the first region in the first direction is 2 times to 10 times a thickness of the second region in the first direction.

12. The vertical non-volatile memory device of any preceding claim, wherein
the resistance change layer has a property where, during switching between the first state and the second state, an element composition distribution in the first region and the second region is maintained constant.

13. The vertical non-volatile memory device of any preceding claim, wherein a thickness of the resistance change layer in the second direction is 5 nm to 100 nm.

14. The vertical non-volatile memory device of any preceding claim, wherein each of the plurality of memory cell strings further comprises a barrier layer extending in the first direction between the channel layer and the resistance change layer,
the barrier layer comprises a carbon-based non-conductor or a nitrogen-based non-conductor, and
a thickness of the barrier layer in the second direction is greater than 0 nm and less than or equal to 10 nm.

15. An electronic device comprising:
a processing circuitry; and
a vertical non-volatile memory device according to any preceding claim connected to the processing circuitry.
